# EUROPEAN PATENT SPECIFICATION

(11) **EP 1 619 716 B1**
(45) Date of publication and mention of the grant of the patent: **02.02.2011**
(21) Application number: 04396051.7
(22) Date of filing: 21.07.2004
(51) Int. Cl.: H01L 21/66

(54) **Pressure testing apparatus and method for pressure testing**
Gerät und Verfahren um Tests unter Druck durchzuführen
Dispositif et procédé pour faire des tests sous pression

(43) Date of publication of application: 25.01.2006
(73) Proprietor: Afore Oy, 20810 Turku (FI)
(72) Inventor: Henttonen, Vesa, 20380 Turku (FI); Hannukainen, Kari, 21260 Raisio (FI)
(74) Representative: Suominen, Kaisa Liisa

(56) References cited:
- JP-A- 08 008 152
- US-A- 4 777 716
- US-A- 5 668 305
- US-A- 5 677 477
- US-A1- 2004 020 438
- US-B1- 6 373 271

## Description

### TECHNICAL FIELD OF THE INVENTION

The invention concerns a pressure testing apparatus, a method for pressure testing chips on a wafer and use of such apparatuses according to the preambles of the independent claims presented below.

### BACKGROUND ART

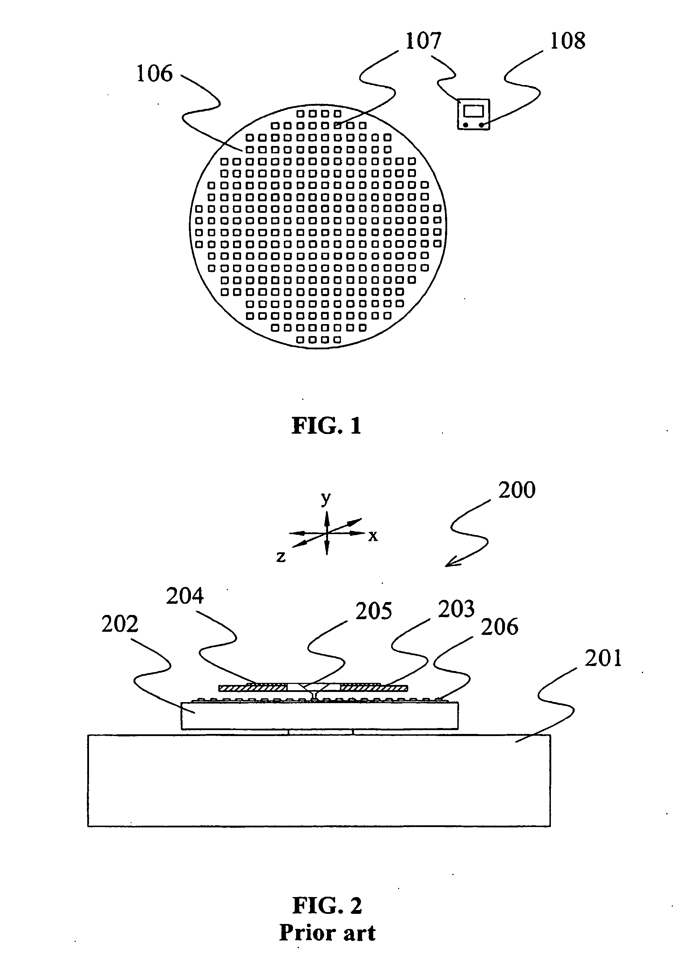

Pressure sensors are micromechanical devices, which are fabricated in a wafer, typically from 100 to 300 mm in diameter and from 200 to 500 µm in thickness. The wafer is mounted in a test fixture so that the performance of the each individual pressure sensors can be tested. Figure 1 shows a wafer. The pressure sensors, referred to as chips in the following text, are tested while still in wafer form or after separation from each other (by dicing), using an automatic testing apparatus.

The testing apparatus typically comprises a chuck for the wafer or the test fixture, a card support for a probe card and a positioning device for positioning the wafer or the test fixture during testing. Most of such testing apparatuses function at normal air pressure. However, for pressure sensors, testing at normal air pressure is insufficient. Therefore pressure sensors should be tested at low pressure and/or at overpressure.

In pressure sensor testing, low pressure may be applied towards the lower surface of the wafer so that the low pressure is produced through the chuck. For proper function, the contact surfaces of the sensor should be located on the opposite side of the active pressure surface in the sensor.

Producing overpressure through the chuck is possible, but then the wafer should be held against the chuck using a force at least equal to the force of pressure below the wafer. Since wafers are typically very thin, breaking of the wafer already at very low overpressure is possible.

For overpressure testing, the active pressure surface and its contacts may be located on the same side of the wafer. In a known technique, a conduit in association with the probes of the probe card, for example needles, is brought near the surface of the sensor. Controlling exactly the flow of blowing, a specific area on the wafer, for example a pressure sensor, is pressurized. However, with flow control it is difficult to obtain an exact pressure. Furthermore, by using such known technique it is difficult to achieve a high pressure of over 10 bars.

Another known technique is to force a conduit closely against the surface of the wafer so that the conduit forms a pressure chamber together with the wafer surface. Thus, pressure control is easier. However, in most cases no high contact force is allowed to be directed toward the wafer surface.

In publication US 4,777,716 a chuck is provided with a seal circumferentially around the wafer. The probe card is located above the chuck below the cover. A pressure sensor to be tested is placed in contact with the probes by moving the chuck upward against the structure above it. Thereby, the chuck becomes tightened against the upper structure and forms a hermetically sealed chamber together with the upper structure. The level of pressure can be varied with aid of an external pressure system. If testing is desired to be done with a great overpressure the pressure force is encountered due to large pressurized area which force tend to open the chamber during testing. The pressure force is directed towards the positioning device of the chuck. Thereby the positioning device should be made heavy by its construction. Another problem is that the force between the sensor and the probes of the probe card cannot be adjusted by the vertical movement of the chuck. Furthermore, the capacity for testing is reduced by the structure of the apparatus. For positioning from one sensor to another sensor, the pressure chamber of the apparatus has to be opened. After closing the chamber it has to be pressurized again.

Publication US 6,373,271 presents another typical solution wherein the above mentioned problems are decreased so that the part of the chuck, which is tightened against the upper structure, is flexible allowing the horizontal movements of the chuck within the specific limits. Thus, opening of a hermetically sealed pressurized chamber between the movements is not required. Flexible construction enables adjustment of applied force between the sensor and the probes of the probe card since the vertical movement is not totally fixed. However, a disadvantage is the great pressure force, which is applied towards the wafer chuck.

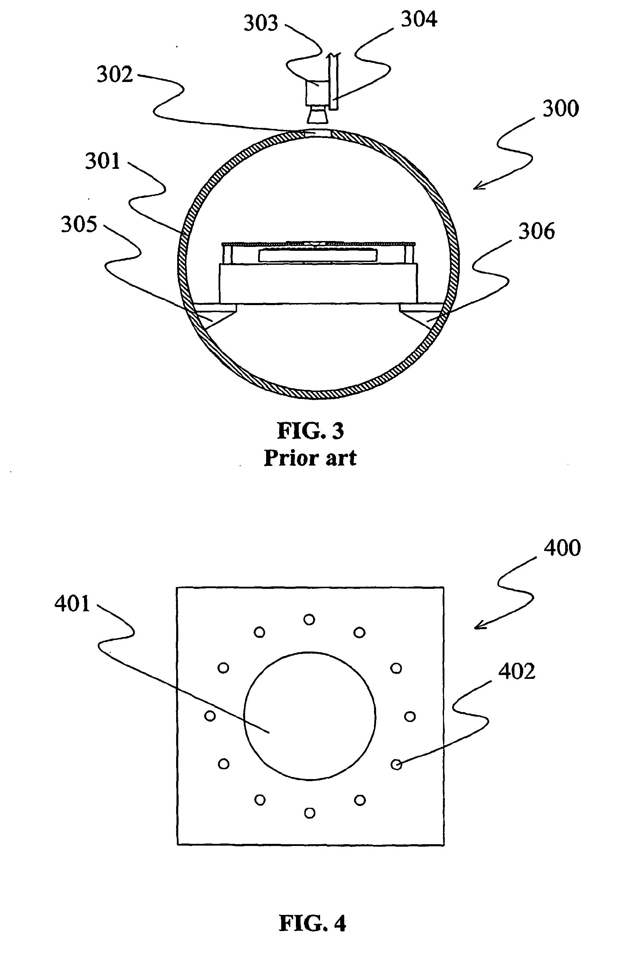

One known technique is shown in Figure 3. The positioning device for the testing apparatus is arranged inside a cylindrical pressure chamber. The pressure chamber experiences a movement due to a change in an applied pressure in the chamber and this movement is conducted to the positioning device through the walls unless the thickness of the wall is well oversized. Thus, the positioning device cannot be fastened rigidly to the walls of the pressure chamber otherwise the movement may cause problems in its positioning accuracy.

Publication US 2004/020438 discloses a workpiece deflection management system comprising a first and a second vacuum chamber, the vacuum chambers having an air-bearing seal circumscribing one of its sides. The air-bearing seals are aligned to face one another with a workpiece plate therebetween, allowing the workpiece to laterally slide with respect to the air-bearing seals while maintaining predefined vacuum levels within the vacuum chambers.

### SUMMARY OF THE INVENTION

It is therefore an object of the invention to provide a pressure testing apparatus that overcomes the above deficiencies.

Furthermore, an object of the invention is to provide a method for pressure testing chips on a wafer in a pressure chamber and a pressure testing apparatus, which can be utilized at low pressure and/or at overpressure testing of such chips.

Furthermore, an object of the invention is to provide a method for pressure testing separated (diced) chips in a test fixture in a pressure chamber, and a pressure testing apparatus, which can be utilized at low pressure and/or at overpressure testing of such chips.

These objects are achieved by the pressure testing apparatus and a method according to independent claims. Furthermore, there is being provided the use of such apparatuses.

Typical pressure testing apparatus according to the invention comprises a pressure chamber, which pressure chamber comprises a housing and a loading means for transporting the wafer through the housing into and out from the pressure chamber, the housing comprising an upper part and a lower part. Typical pressure testing apparatus comprises further a support plate arranged between the upper and lower parts of the housing, a wafer chuck, a testing means for testing chips, and a positioning device for positioning the chuck and the chips relative to the testing means.

With the testing means is meant for example probes and a probe card to control measuring in the pressure testing apparatus and a card support to support the probe card. With chips is meant for example pressure sensors, gas sensors or circuits on a wafer or in a test fixture. The chips are sometimes referred to as die. In the following text, the wafer may correspond to the test fixture for the chips although not specifically mentioned. With the test fixture is meant for example a plate comprising a place for the each individual chips. The test fixture may be for example a metal lattice, a frame or a waffle-type carrier. Furthermore, the test fixture may be accomplished by substrate material to which the chips are attached, glued or bonded. The wafer may be for example made of glass or semiconducting material, such as silicon or gallium arsenide.

In typical pressure testing apparatus according to the invention the wafer chuck, the testing means and the positioning device are supported to the support plate and arranged inside the pressure chamber, and furthermore the support plate comprises inside the pressure chamber an opening providing a gas connection between the upper and lower parts of the housing. In typical pressure testing apparatus the upper part and the lower part are fastened to the support plate by fastening means.

In typical pressure testing apparatus, the purpose of the opening is to provide same pressure into the lower part and the upper part of the housing. This way same pressure is applied on both sides of the support plate. The forces towards the upper part of the support plate are likely to be compensated with forces towards the lower part. Thus, the support plate is not bent due to the applied pressure. Furthermore, the structure of the pressure chamber of the pressure testing apparatus enables the use of relatively thin support plate, since the moving force is exerted to the positioning device, the wafer chuck and the testing means only in the planar direction of the support plate. Although the movement of the housing due to changes in applied pressure may cause the positioning device and the wafer chuck to be moved to some extent, the effect of the movement is less than in the case where the positioning device is supported directly to the wall of the housing, as is presented in prior art techniques. In other words, the movement from the housing of the pressure chamber is attenuated by the support plate. Since a wafer or a test fixture containing chips to be tested lies in the wafer chuck, which is supported to the support plate as well as the testing means is supported to the support plate, it becomes possible to improve the accuracy of the positioning device in the pressure testing apparatus.

In a further embodiment of the invention, the support plate is arranged to cover a collar around the periphery of the pressure chamber. The size of the collar depends on the size of the support plate. The width/length of the support plate may be around 1000 millimetres. The outer diameters of the upper and lower parts may be 500-700 millimetres. Thereby the width of the collar around the said periphery may be 150-250 millimetres.

In another further embodiment of the invention the support plate extends from inside of the housing of the pressure chamber to a distance outside of the housing of the pressure chamber. Since the support plate is provided with an opening inside the pressure chamber, the distance extends beginning from the edge of the opening to outside the housing. Thus, the distance may be 300-700 millimetres depending on the size of the support plate and the diameter of the opening.

In another further embodiment of the invention, the support plate is arranged to divide the housing of the pressure chamber into an upper part and a lower part. The upper part may be similar than the lower part or they can be dissimilar. The upper and lower parts and the support plate are however arranged to form a hermetically sealed pressure chamber.

In another further embodiment of the invention the upper part and the lower part are separate parts, which are supported to the support plate. The upper part of the housing is supported to the upper side of the support plate. The upper part provides an upper chamber, which chamber extends above the positioning device and the support plate. Thus, the loading means and the wafer chuck may be arranged in the upper part. Furthermore, the loading means is preferably arranged nearby the wafer chuck. The lower part of the housing is supported to the lower side of the support plate. The lower part provides a lower chamber, which lower chamber extends below the positioning device and the support plate. The positioning device is thus arranged between the upper chamber and the lower chamber.

The pressure is same inside said chambers since the opening provides a gas connection through the support plate. Thus, the pressure forces towards the upper side of the support plate from the upper chamber are to be compensated by the pressure forces towards the lower side of the support plate from the lower chamber.

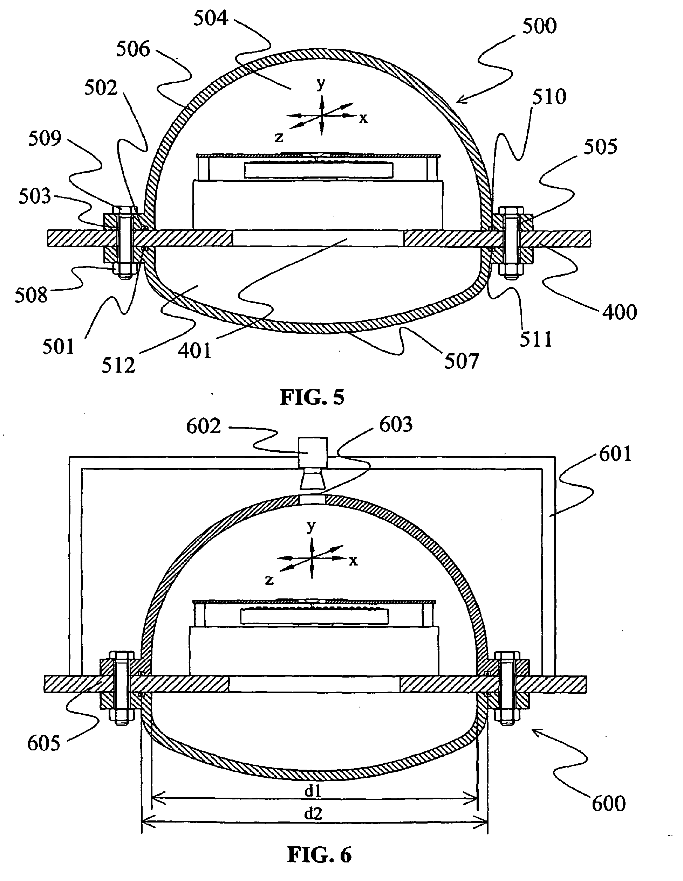

In another further embodiment of the invention the opening covers a part from the support plate inside the pressure chamber. The opening is then entirely inside the pressure chamber. Furthermore, the support plate may be continuous around the opening. The diameter of the opening is for example 2.5, 5, 10, 15, 20, 30, 40 or 50 percent smaller than the inner diameter d1 of the housing shown in Figure 6. The diameter of the opening may be for example 15, 30, 60, 90, 120, 180, 240 or 300 mm smaller than the inner diameter d1. Therefore, the diameter of the opening is smaller than the inner diameter of the housing. Thus, the area of the opening of the support plate inside the pressure chamber is smaller than the area of the support plate inside the pressure chamber which area is defined by the housing and includes also the area of the opening.

In another further embodiment of the invention the testing means comprises a probe card. The probe card is provided with contact probes by means of which a singular chip or several chips on a wafer may be tested.

In another further embodiment of the invention the testing means comprises a card support arranged to support the probe card. The card support may be supported directly to the support plate or to the positioning device arranged in the support plate.

In another further embodiment of the invention the pressure testing apparatus comprises a vision system supported to the support plate. Such system may comprise a camera, a microscope and/or a light source.

In another further embodiment of the invention the pressure testing apparatus comprises a window arranged in the housing of the pressure chamber. The window or windows may be then arranged below the vision system if the vision system is arranged outside the pressure chamber. Both the vision system and the windows may be arranged above the upper part of the housing.

The invention concerns furthermore a method for pressure testing chips on a wafer in a pressure chamber, the pressure chamber comprising a housing and a loading means for transporting the wafer through the housing into and out from the pressure chamber, the housing comprising an upper part and lower part, the method comprising, inserting a wafer into a wafer chuck, positioning the wafer chuck relative to a testing means with a positioning device, supporting a testing means by a support plate, changing pressure inside the housing of the pressure chamber thereby moving the housing of the pressure chamber and testing the chips on the wafer in the pressure chamber with the testing means.

In typical method according to the invention, the method comprises supporting the wafer chuck and the positioning device by the support plate, arranging the testing means and the positioning device inside the housing of the pressure chamber, providing an opening and thereby a gas connection through the support plate between the upper chamber and the lower chamber, supporting the upper part of the housing to the upper side of the support plate by fastening means, thus providing an upper chamber, supporting the lower part of the housing to the lower side of the support plate by fastening means, thus providing a lower chamber applying equal pressure against the upper and lower surface of the support plate.

In a further embodiment of the invention the method comprises exerting moving force caused by the movement of the housing of the pressure chamber due to the pressure change to the wafer chuck, the testing means and the positioning device only via the support plate.

The invention further relates to the use of a pressure testing apparatus according to present invention for chips on a wafer. For example testing sensors of poisonous gases, for example chemical war gases, can be done safely and effectively.

The details and embodiments described above in connection with the pressure testing apparatus also apply to the present method.

### BRIEF DESCRIPTION OF THE DRAWINGS

The invention will now be described by way of examples only with reference to accompanying drawings, in which
- Figure 1: shows a top view of a wafer that includes chips to be tested,
- Figure 2: shows a cross-sectional view of a testing apparatus according to prior art,
- Figure 3: shows a cross-sectional view of a pressure testing apparatus according to prior art,
- Figure 4: shows a top view of a support plate according to a first embodiment of the invention presented in Figure 5, .
- Figure 5: shows a cross-sectional view of a pressure testing apparatus according to a first embodiment of the invention,
- Figure 6: shows a cross-sectional view of a pressure testing apparatus according to a second embodiment of the invention,
- Figure 7: shows a cross-sectional view of a loading means according to a third embodiment of the invention.

### DETAILED DESCRIPTION OF THE DRAWINGS

Figure 1 shows a top view of a wafer that includes chips to be tested. The wafer 106 contains chips 107, such as pressure sensors. The wafer 106 may contain from 100 to 1000 chips. Furthermore, the chip 107 comprises contact pads 108.

Figure 2 is a cross-sectional view of a testing apparatus according to prior art. It should be noted that the testing apparatus might not be necessarily applied for pressure testing chips without a pressure chamber. The testing apparatus 200 consist of a positioning device 201, a chuck 202 and testing means such as a probe card 204, probes 205 and a card support 203. The positioning device 201 for positioning the chuck 202 is arranged so that the chuck can be moved along the x-, y- and z-axes of the Cartesian coordinate system as is shown by arrows as is shown in Figure 2. The probe card 204 and its probes 205 are arranged in the card support 203 above the wafer chuck 202.

For testing a chip, the wafer is inserted into the wafer chuck 202 and fastened on it in a manner well known in the art and will not be described herein. The wafer chuck 202 is moved into a position of device under test or a chip by the positioning device 201 so that the probes 205 can be placed in contact with the contact pads of the chip. The probes of the probe card are forced against the contact pads of the chip and measurements are executed at normal air pressure by the testing means.

Referring to Figure 3, a cross-sectional view of a pressure testing apparatus according to prior art is shown. The pressure testing apparatus 300 may be partially analogous with the testing apparatus 200 shown in Figure 2. The pressure testing apparatus comprises a cylindrical pressure chamber 301 provided with a window 302 and a camera 303. The positioning device is mounted to the inner walls of the housing of the pressure chamber by rails 305 and 306. The camera is positioned outside the pressure chamber in a rack 304.

At overpressure, the pressure tends to direct the force towards the walls of the pressure chamber thus pushing the opposite walls and the rails 305, 306 apart. The movement is conducted to the positioning device through the walls unless the thickness of the wall is well oversized. The pressure chamber 301 may expand freely since there is no support arranged outside the housing of the pressure chamber, by which the expansion could be attenuated. Thus, the positioning device is moved undesirably during testing and its accuracy is degraded.

Figure 4 shows a top view of a support plate according to a first embodiment of the invention presented in Figure 5. The support plate 400 contains holes 402, which are circumferentially positioned around the opening 401. The opening 401 is entirely inside the continuous support plate 400. The shape of the opening may vary. For example, the opening may be rectangular in shape. In Figure 4, the opening is circular and arranged inside the periphery of the holes 402. The radius of the opening 401 is chosen so that the positioning device can be supported from the edges of the opening inside the periphery of the holes by the support plate. The radius is around 100-400 millimetres depending on the size of the support plate.

Figure 5 shows a cross-sectional view of a pressure testing apparatus according to a first embodiment of the invention. The pressure testing apparatus 500 comprises a housing of a pressure chamber provided with an upper part 506 and a lower part 507 and a support plate. The pressure testing apparatus further comprises a testing means, such as probe cards and probes and a card support, a wafer chuck for holding the chips, a positioning device for positioning the wafer chuck and the chips relative to the testing means, as is shown more detailed in Figure 2. The upper part of the housing is mounted to the upper side of the support plate, thus providing an upper chamber 504. The lower part of the housing is mounted to the lower side of the support plate, thus providing a lower chamber 512. Further, the pressure testing apparatus 500 comprises sealed lead-throughs (not shown) for the electrical cables from the probes and the probe card as well as the positioning device. The pressure testing apparatus is also provided with sealed lead-throughs and ducts for the external pumping system (not shown).

Referring further to Figure 5, the upper part 506 of the housing of the pressure chamber is provided with a groove 502 and holes 505. An O-ring seal 510 is arranged in the groove 502. The lower part 507 of the housing of the pressure chamber is provided with a groove 501 and holes 503. Furthermore, the lower part 507 is equipped with an O-ring seal 511. Grooves 501 and 502 and seals 510 and 511 are arranged opposite each other on both sides of the support plate.

In Figure 5, the card support is arranged in the positioning device above the chuck. Alternatively the card support may be arranged in the support plate 400 inside the pressure chamber. The upper part 506 and the lower part 507 are fastened to the support plate 400 by fastening means, for example by bolts 509 and nuts 508, through the holes 503, 505, 402, as is shown in Figures 4 and 5. The upper part and the lower part are adapted so that the surfaces with grooves 501, 502 are positioned against the support plate 400. The support plate 400 is arranged horizontally between the upper part 506 and the lower part 507 of the housing of the pressure chamber. Thereby the support plate, the upper part and the lower part confine a hermetically sealed chamber.

The diameters of holes 503, 505, 402 are slightly larger than the diameter of bolts 509. Thus, the bolts fasten the upper part firmly to the lower part but allow limited movement of the housing in relation to the support plate. This way the movement of the housing stresses less the support plate and thus makes it possible to use thinner support plates. For example, the thickness of the support plate is around 20 millimetres. The material of the support plate is for example stainless steel.

The difference between the inner diameter of the housing d1 and the outer diameter of the housing, that is the thickness of the wall of the pressure chamber, is significantly greater than is required by the applied pressure in the pressure chamber. The thickness of the wall of the pressure chamber is for example three, four or five times greater than is required by the applied pressure in the pressure chamber.

Referring to Figure 6, a cross-sectional view of a pressure testing apparatus according to a second embodiment of the invention is shown. A support plate 605 is extended to a distance away from outer edges of the housing of the upper part and/or the lower part. Arranged in the support plate 605 is a standing support 601 for a camera 602. The pressure testing apparatus comprises the camera, which is placed on the standing support above the upper part. The upper part of the pressure apparatus is provided with a window 603, which is positioned above the wafer chuck.

In the example of the Figure 6, areas delimited by the seals and against the upper and lower surfaces of the support plate are equal. The seals are circular in shape and their diameters d2 are equal. That is the seals are equal in size. The seals are circumferentially arranged around the upper and the lower parts of the housing.

Furthermore, the inner diameter d1 of the open surface of the upper part of the housing towards the support plate is equal to the inner diameter of the open surface of the lower part towards the support plate. For example d1 is around 600 millimetres and d2 is around 650 millimetres. Thus the diameter of the opening may be around 400 millimetres.

In order to test chips the pressure chamber is opened by loosening the nuts and bolts, and the wafer is inserted into the wafer chuck inside the housing of the pressure chamber. The wafer is fastened on the wafer chuck in a manner well known those skilled in the art. The pressure chamber is hermetically closed by tightening the nuts and bolts. The test is carried out either at low pressure or at overpressure. The pressure is drawn in the pressure chamber by an external pressure system, for example by mechanical pumping and/or cryogenic pumping. For pressure testing, the wafer is moved by the positioning device in a desired position and the probes are placed in contact with the contact pads of the chip, for example a pressure sensor. The wafer chuck is positioned desirably along x-, y- and z-axes of Cartesian coordinate system as shown in Figure 6. The chip is tested by the testing means inside the housing of the pressure chamber. When the test is completed the pressure is returned to normal air pressure, for example by opening the air valves arranged in the pressure chamber (not shown).

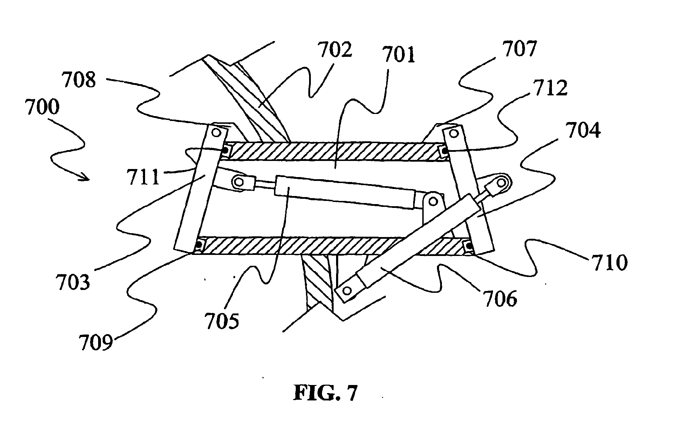

Referring to Figure 7, a cross-sectional view of a loading means according to a third embodiment of the invention is shown. The pressure testing apparatus may be provided with the loading means 700 for transporting the wafer through the housing into and out from the pressure chamber. The loading means comprises an entrance chamber 701 arranged into the wall of the housing of the pressure chamber 702, preferably in the upper part of the housing and nearby the wafer chuck. Furthermore, the loading means comprises an inner lid 703, an outer lid 704, an inner groove 709, an outer groove 710, an inner seal 711 and an outer seal 712. The loading means may further contains hinge 707, 708. Thereby the lids are pivotally mounted into the walls of the entrance chamber. The entrance chamber may be provided with a pressure gauge (not shown) for measuring the pressure. The inner lid is connected with the first actuator 705 to the entrance chamber. The outer lid is connected with the second actuator 706 to the entrance chamber. The lids 703, 704 are opened and closed with the actuators 705, 706. During pressure testing, if there is a low pressure in the pressure chamber the outer lid is sealed tightly against the entrance chamber. When there is an overpressure in the pressure chamber the inner lid is sealed tightly against the entrance chamber. Additionally, low pressure may be applied into the entrance chamber during testing for sealing the chamber. Furthermore, overpressure may be applied in the entrance chamber to prevent contaminant entering the entrance chamber during loading.

It should be noted that a person skilled in art might modify the pressure testing apparatus by using movable testing means, such as probes and probe card, instead of using positioning device. Thereby, the mechanics and the chuck could be held in place if the testing means were moved. Further, instead of arranging grooves in the upper and lower part of the housing, the grooves may be arranged in the support plate. Thus the seals may also be arranged in the support plate. Although, the present invention utilizes O-ring seals 510, 511, the various types of seals may be used.

While the invention has been shown and described with reference to certain embodiments thereof, these are merely provided to illustrate the invention. Thus, it will be understood by those skilled in the art that various modifications in the form and details can be made therein without departing from the scope of the invention.

## Claims

1. A pressure testing apparatus (500, 600) for chips (107) on a wafer (106), the apparatus (500, 600) comprising
- a pressure chamber (504, 512) comprising a housing and a loading means (700) for transporting the wafer (106) through the housing into and out from the pressure chamber (504, 512), the housing comprising an upper part (506) and a lower part (507),
- a wafer chuck (202), a testing means (203, 204, 205) for testing chips and a positioning device (201), arranged inside the pressure chamber (504, 512),
wherein the apparatus comprises a support plate (400, 605) arranged between the upper and lower parts (506, 507) of the housing, the upper part (506) and the lower part (507) being fastened to the support plate (400, 605) by fastening means (508, 509), and wherein the wafer chuck (202), the testing means (203, 204, 205) and the positioning device (201) are supported to the support plate (400, 605) and furthermore wherein the support plate (400, 605) comprises inside the pressure chamber (504, 512) an opening (401) providing a gas connection between the upper and lower parts (506, 507) of the housing.

2. A pressure testing apparatus (500, 600) according to claim 1, wherein the support plate (400, 605) is arranged to cover a collar around the periphery of the pressure chamber (504, 512).

3. A pressure testing apparatus (500, 600) according to claim 1, wherein the support plate (400, 605) is arranged to divide the housing of the pressure chamber (504, 512) into an upper part (506) and a lower (507) part.

4. A pressure testing apparatus (500, 600) according to claim 3, wherein the upper part (506) and the lower part (507) are separate parts which are supported to the support plate (400, 605).

5. A pressure testing apparatus (500, 600) according to claim 1, wherein the support plate (400, 605) extends from inside of the housing of the pressure chamber (504, 512) to a distance outside of the housing of the pressure chamber (504, 512).

6. A pressure testing apparatus (500, 600) according to claim 1, wherein the opening covers a part of the support plate (400, 605) inside the pressure chamber (504, 512).

7. A pressure testing apparatus (500, 600) according to claim 1, wherein the testing means comprises a probe card (204).

8. A pressure testing apparatus (500, 600) according to claim 7, wherein the testing means comprises a card support (203) arranged to support the probe card (204).

9. A pressure testing apparatus (500, 600) according to claim 1, wherein the pressure testing apparatus (500, 600) comprises a vision system (602) supported to the support plate (400, 605).

10. A pressure testing apparatus (500, 600) according to claim 1, wherein it comprises a window (603) arranged in the housing of the pressure chamber (504, 512).

11. A method for pressure testing chips (107) on a wafer (106) in a pressure chamber (504, 512), the pressure chamber (504, 512) comprising a housing and a loading means (700) for transporting the wafer (106) through the housing into and out from the pressure chamber (504,512), the housing comprising an upper part (506) and lower part (507), the method comprising,
- inserting a wafer (106) into a wafer chuck (202),
- positioning the wafer chuck (202) relative to a testing means (203, 204, 205) with a positioning device (201),
- arranging the testing means (203, 204, 205) and the positioning device (201) inside the housing of the pressure chamber (504, 512),
- changing pressure inside the housing of the pressure chamber (504, 512), thereby moving the housing of the pressure chamber (504, 512),
- testing the chips (107) on the wafer (106) in the pressure chamber (504, 512) with a testing means (203, 204, 205),
- supporting the testing means (203, 204, 205), the wafer chuck (202) and the positioning device (201) by a support plate (400, 605),
- providing an opening (401) and thereby a gas connection through the support plate (400, 605) between the upper chamber (504) and the lower chamber (512),
- supporting the upper part (506) of the housing to the upper side of the support plate (400, 605) by fastening means (508, 509), thus providing an upper chamber (504),
- supporting the lower part (507) of the housing to the lower side of the support plate (400, 605) by fastening means (508, 509), thus providing a lower chamber (512),
- applying equal pressure against the upper and lower surface of the support plate (400, 605).

12. Use of a pressure testing apparatus (500, 600) according to any of the previous claims 1 to 10 as a pressure testing apparatus (500, 600) for chips (107) on a wafer (106).

13. Use of a pressure testing apparatus (500, 600) according to claim 12, wherein the chips (107) are gas sensors.

## Patentansprüche

1. Drucktestvorrichtung (500, 600) für Chips (107) auf einem Wafer (106), wobei die Vorrichtung (500, 600) aufweist:
- eine Druckkammer (504, 512) mit einem Gehäuse und einer Ladeeinrichtung (700) zum Transportieren des Wafers (106) durch das Gehäuse in die und aus der Druckkammer (504, 512), wobei das Gehäuse einen oberen Teil (506) und einen unteren Teil (507) aufweist,
- eine Wafer-Festspanneinrichtung (202), eine Testeinrichtung (203, 204, 205) zum Testen der Chips und eine innerhalb der Druckkammer (504, 512) angeordnete Positionierungseinrichtung (201), wobei die Vorrichtung eine Trägerplatte (400, 605) aufweist, die zwischen den oberen und unteren Teilen (506, 507) des Gehäuses angeordnet ist, wobei der obere Teil (506) und der untere Teil (507) an der Trägerplatte (400, 605) durch eine Befestigungseinrichtung (508, 509) befestigt sind, und wobei die Wafer-Festspanneinrichtung (202), die Testeinrichtung (203, 204, 205) und die Positionierungseinrichtung (201) auf der Trägerplatte (400, 605) gelagert sind, und wobei die Trägerplatte (400, 605) ferner innerhalb der Druckkammer (504, 512) eine Öffnung (401) aufweist, die eine Gasverbindung zwischen dem oberen und dem unteren Teil (506, 507) des Gehäuses vorsieht.

2. Drucktestvorrichtung (500, 600) nach Anspruch 1, wobei die Trägerplatte (400, 605) dafür eingerichtet ist, einen Bund um den Umfang der Druckkammer (504, 512) herum zu überdecken.

3. Drucktestvorrichtung (500, 600) nach Anspruch 1, wobei die Trägerplatte (400, 605) dafür eingerichtet ist, das Gehäuse der Druckkammer (504, 512) in einen oberen Teil (506) und einen unteren Teil (507) zu unterteilen.

4. Drucktestvorrichtung (500, 600) nach Anspruch 3, wobei der obere Teil (506) und der untere Teil (507) getrennte Teile sind, welche an der Trägerplatte (400, 605) gehalten sind.

5. Drucktestvorrichtung (500, 600) nach Anspruch 1, wobei sich die Trägerplatte (400, 605) vom Inneren des Gehäuses der Druckkammer (504, 512) bis zu einem Abstand außerhalb des Gehäuses der Druckkammer (504, 512) erstreckt.

6. Drucktestvorrichtung (500, 600) nach Anspruch 1, wobei die Öffnung einen Teil der Trägerplatte (400, 605) innerhalb der Druckkammer (504, 512) überdeckt.

7. Drucktestvorrichtung (500, 600) nach Anspruch 1, wobei die Testeinrichtung eine Prüfkarte (204) aufweist.

8. Drucktestvorrichtung (500, 600) nach Anspruch 7, wobei die Testeinrichtung einen Kartenträger (203) aufweist, der dafür eingerichtet ist, die Prüfkarte (204) zu tragen.

9. Drucktestvorrichtung (500, 600) nach Anspruch 1, wobei die Drucktestvorrichtung (500, 600) ein Betrachtungssystem (602) aufweist, das an der Trägerplatte (400, 605) gehalten ist.

10. Drucktestvorrichtung (500, 600) nach Anspruch 1, wobei diese ein Fenster (603) aufweist, das in dem Gehäuse der Druckkammer (504, 512) angeordnet ist.

11. Verfahren zum Drucktesten von Chips (107) auf einem Wafer (106) in einer Druckkammer (504, 512), wobei die Druckkammer (504, 512) ein Gehäuse und eine Ladeeinrichtung (700) zum Transportieren des Wafers (106) durch das Gehäuse in die und aus der Druckkammer (504, 512) aufweist, wobei das Gehäuse einen oberen Teil (506) und einen unteren Teil (507) aufweist, und das Verfahren die Schritte aufweist:
- Einsetzen eines Wafers (106) in eine Wafer-Festspanneinrichtung (202),
- Positionieren der Wafer-Festspanneinrichtung (202) in Bezug auf eine Testeinrichtung (203, 204, 205) mittels einer Positionierungseinrichtung (201),
- Anordnen der Testeinrichtung (203, 204, 205) und der Positionierungseinrichtung (201) im Inneren des Gehäuses der Druckkammer (504, 512),
- Ändern des Drucks im Inneren des Gehäuses der Druckkammer (504, 512), und **dadurch** Bewegen des Gehäuses der Druckkammer (504, 512),
- Testen der Chips (107) auf dem Wafer (106) in der Druckkammer (504, 512) mit einer Testeinrichtung (203, 204, 205),
- Haltern der Testeinrichtung (203, 204, 205), der Wafer-Festspanneinrichtung (202) und der Positionierungseinrichtung (201) mittels einer Trägerplatte (400, 605),
- Vorsehen einer Öffnung (401) und **dadurch** einer Gasverbindung durch die Trägerplatte (400, 605) zwischen der oberen Kammer (504) und der unteren Kammer (512),
- Haltern des oberen Teils (506) des Gehäuses an der Oberseite der Trägerplatte (400, 605) durch eine Befestigungseinrichtung (508, 509), um somit eine obere Kammer (504) vorzusehen,
- Haltern des unteren Teils (507) des Gehäuses an der Unterseite der Trägerplatte (400, 605) durch eine Befestigungseinrichtung (508, 509), um somit eine untere Kammer (512) vorzusehen,
- Anlegen eines gleichen Druckes gegen die obere und untere Oberfläche der Trägerplatte (400, 605).

12. Verwendung einer Drucktestvorrichtung (500, 600) nach einem der vorstehenden Ansprüche 1 bis 10 als eine Drucktestvorrichtung (500, 600) für Chips (107) auf einem Wafer (106).

13. Verwendung der Drucktestvorrichtung (500, 600) nach Anspruch 12, wobei die Chips (107) Gassensoren sind.

## Revendications

1. Dispositif pour faire des tests sous pression (500, 600) destinés à des puces (107) sur une plaquette (106), le dispositif (500, 600) comprenant :
- une chambre de pression (504, 512) comportant une enceinte et des moyens de chargement (700) pour transporter la plaquette (106) à travers l'enceinte dans et hors de la chambre de pression (504, 512), l'enceinte comportant une partie supérieure (506) et une partie inférieure (507),
- un support individuel de plaquette (202), des moyens de test (203, 204, 205) servant à tester les puces et un dispositif de positionnement (201), disposés à l'intérieur de la chambre de pression (504, 512),
dans lequel le dispositif comprend une plaque de support (400, 605) disposée entre les parties supérieure et inférieure (506, 507) de l'enceinte, la partie supérieure (506) et la partie inférieure (507) étant fixées à la plaque de support (400, 605) par des moyens de fixation (508, 509), et dans lequel le support individuel de plaquette (202), les moyens pour faire des tests (203, 204, 205) et le dispositif de positionnement (201) sont supportés par la plaque de support (400, 605) et dans lequel, de plus, la plaque de support (400, 605) comporte à l'intérieur de la chambre de pression (504, 512)une ouverture (401) fournissant une connexion de gaz entre les parties supérieure et inférieure (506, 507) de l'enceinte.

2. Dispositif pour faire des tests sous pression (500, 600) selon la revendication 1, dans lequel la plaque de support (400, 605) est agencée en vue de recouvrir un collier autour de la périphérie de la chambre de pression (504, 512).

3. Dispositif pour faire des tests sous pression (500, 600) selon la revendication 1, dans lequel la plaque de support (400, 605) est agencée de façon à diviser l'enceinte de la chambre de pression (504, 512) en une partie supérieure (506) et en une partie inférieure (507).

4. Dispositif pour faire des tests sous pression (500, 600) selon la revendication 3, dans lequel la partie supérieure (506) et la partie inférieure (507) sont des parties séparées qui sont supportées sur la plaque de support (400, 605).

5. Dispositif pour faire des tests sous pression (500, 600) selon la revendication 1, dans lequel la plaque de support (400, 605) s'étend à partir de l'intérieur de l'enceinte de la chambre de pression (504, 512) sur une certaine distance à l'extérieur de l'enceinte de la chambre de pression (504, 512).

6. Dispositif pour faire des tests sous pression (500, 600) selon la revendication 1, dans lequel l'ouverture couvre une partie de la plaque de support (400, 605) à l'intérieur de la chambre de pression (504, 512).

7. Dispositif pour faire des tests sous pression (500, 600) selon la revendication 1, dans lequel les moyens de test comportent une carte sonde (204).

8. Dispositif pour faire des tests sous pression (500, 600) selon la revendication 7, dans lequel les moyens de tests comprennent un support de carte (203) disposé afin de supporter la carte sonde (204).

9. Dispositif pour faire des tests sous pression (500, 600) selon la revendication 1, dans lequel le dispositif pour faire des tests sous pression (500, 600) comporte un système de vision (602) supporté par la plaque de support (400, 605).

10. Dispositif pour faire des tests sous pression (500, 600) selon la revendication 1, qui comprend une fenêtre (603) agencée dans l'enceinte de la chambre de pression (504, 512).

11. Procédé pour tester sous pression des puces (107) sur une plaquette (106) dans une chambre de pression (504, 512), la chambre de pression (504, 512) comprenant une enceinte et des moyens de chargement (700) pour transporter la plaquette (106) à travers l'enceinte à l'intérieur et en dehors de la chambre de pression (504, 512), l'enceinte comprenant une partie supérieure (506) et une partie inférieure (507), le procédé comprenant le fait de :
- insérer une plaquette (106) sur un support individuel de plaquettes(202),
- positionner le support individuel de plaquettes (202) par rapport aux moyens de tests (203, 204, 205) avec un dispositif de positionnement (201),
- agencer les moyens de test (203, 204, 205) et le dispositif de positionnement (201) à l'intérieur de l'enceinte de la chambre de pression (504, 512),
- modifier la pression à l'intérieur de l'enceinte de la chambre de pression (504, 512), déplaçant, de ce fait, l'enceinte de la chambre de pression (504, 512),
- tester les puces (107) sur la plaquette (106) dans la chambre de pression (504, 512) avec les moyens de test (203, 204, 205),
- supporter les moyens de test (203, 204, 205), le support individuel de plaquettes (202) et le dispositif de positionnement (201) au moyen d'une plaque de support (400, 605),
- fournir une ouverture (401) et, de ce fait, une connexion de gaz à travers la plaque de support (400, 605) entre la chambre supérieure (504) et la chambre inférieure (512),
- supporter la partie supérieure (506) de l'enceinte sur le côté supérieur de la plaque de support (400, 605) par des moyens de fixation (508, 509), fournissant ainsi une chambre supérieure (504),
- supporter la partie inférieure (507) de l'enceinte sur le côté inférieur de la plaque de support (400, 605) par des moyens de fixation (508, 509), fournissant ainsi une chambre inférieure (512),
- appliquer une pression égale contre les surfaces supérieure et inférieure de la plaque de support (400, 605).

12. Utilisation d'un dispositif pour faire des tests sous pression (500, 600) selon l'une quelconque des revendications précédentes 1 à 10 en tant que dispositif pour faire des tests sous pression (500, 600) destinés à des puces (107) se trouvant sur une plaquette (106).

13. Utilisation d'un dispositif pour faire des tests sous pression (500, 600) selon la revendication 12, dans lesquels les puces (107) sont des détecteurs de gaz.
